# FASCICULE DE BREVET EUROPEEN

(11) **EP 0 939 447 B1**
(45) Date de publication et mention de la délivrance du brevet: **19.07.2006**
(21) Numéro de dépôt: 99400446.3
(22) Date de dépôt: 24.02.1999
(51) Int. Cl.: H01L 31/0304, H01L 31/18, H01L 31/109, H01L 33/00, C30B 29/40

(54) **Alliage à base d'indium, transducteur infrarouge utilisant un tel alliage et son procédé de fabrication**
Indiumbasierte Legierung, seine Verwendung in einem Infrarotwandler und dessen Herstellungsverfahren
Indium based alloy, infrared transducer using the same and its fabrication method

(30) Priorité: 26.02.1998 FR 9802344
(43) Date de publication de la demande: 01.09.1999
(73) Titulaire: SAGEM Défense Sécurité, 75015 Paris (FR)
(72) Inventeur: Verie, Christian, 06600 Antibes (FR); Lorans, Dominique, 86000 Poitiers (FR); Poirier, Michel, 95300 Pontoise (FR)
(74) Mandataire: Loisel, Bertrand

(56) Documents cités:
- WO-A-96/05621
- US-A- 4 184 171
- US-A- 5 462 008
- US-A- 5 577 061
- PATENT ABSTRACTS OF JAPAN vol. 007, no. 049 (E-161), 25 février 1983 & JP 57 197877 A (NIPPON DENKI KK), 4 décembre 1982
- ASAHI H ET AL: "New semiconductors TlInGaP and their gas source MBE growth" PROCEEDINGS OF THE NINTH INTERNATIONAL CONFERENCE ON MOLECULAR BEAM EPITAXY, MALIBU, CA, USA, 5-9 AUG. 1996, vol. 175-1762, pages 1195-1199, XP002081274 ISSN 0022-0248, Journal of Crystal Growth, May 1997, Elsevier, Netherlands
- POLYAKOV A.Y. ET AL: 'Growth and characterization of InAs(1-x)Sb(x) layers on GaSb substrates' PROCEEDINGS OF THE EIGHTEENTH INTERNATIAL SYMPOSIUM ON GALLIUM ARSENIDE AND RELATED COMPOUNDS no. 120, 09 Septembre 1991, SEATTLE, WASHINGTON, USA, pages 83 - 88, XP000270581

## Description

L'invention concerne les alliages comprenant, en plus d'au moins un élément lourd de la colonne III de la classification de Mendéleïev, à savoir l'indium ou le thallium, au moins deux éléments du groupe V, utilisables sur un substrat monocristallin en un composé, généralement binaire, d' éléments des groupes III et V pour constituer un transducteur infrarouge d'émission, telle qu'une diode électroluminescente, ou un détecteur d'infrarouge, telle qu'une photodiode.

On a déjà proposé de nombreux semiconducteurs composites en vue de la détection infrarouge. Un matériau largement utilisé est (Cd, Hg) Te, déposé par croissance cristalline épitaxiée sur un substrat monocristallin en (Cd Te) ou (Cd, Zn) Te. Ces combinaisons d'éléments des groupes II et VI de la classification périodique présentent divers inconvénients. Leur bande interdite varie très rapidement avec la composition de l'alliage de sorte qu'il est difficile de réaliser des matrices à grand nombre de pixels ayant tous la même longueur d'onde de coupure ; le réseau cristallin présente de nombreux défauts, notamment dans les détecteurs d'infrarouge thermique, ce qui génère du bruit.

On a également proposé divers composants associant des éléments des groupes III et V, notamment :
(In₁₋ₓ Tlₓ)P sur un substrat en InP
(In₁₋ₓTlₓ)As sur un substrat en In As
(In₁₋ₓTlₓ)Sb sur un substrat In Sb
(In₁₋ₓTlₓ)(As_{1-y}P_{y}) sur un substrat en InP

On sait par ailleurs que la plupart des transducteurs sont prévus pour fonctionner par la plage des 3 à 5 microns (infrarouge moyen) ou de 8 à 12 microns (infrarouge thermique). Les composés ci-dessus, décrits dans le document WO 96/05621 auquel on pourra se reporter, ne permettent pas de remplir simultanément, et à un degré suffisant, les deux conditions nécessaires pour réaliser des transducteurs à grand nombre de pixels, c'est à dire être adaptables en longueur d'onde de coupure par simple changement des proportions des composants, et ne présenter que de très faibles défauts de cristallisation lorsqu'ils sont constitués par croissance épitaxiale sur un substrat approprié.

Le document US-A-4 184 171 décrit une LED infrarouge dans la bande de 3 - 5 µm utilisant une alliage In (AsₓSb₁₋ₓ) sur des substrats AlSb ou GaSb. L'alliage a une structure cristalline blende de zinc dont la maille correspond à celle du substrat.

La présente invention vise notamment à fournir un matériau semi-conducteur épitaxié permettant de constituer un transducteur opérant pour des longueurs d'onde ajustables, notamment la bande 3-5 µm ou la bande 8-12 µm, ayant une structure cristalline du type blende de zinc dont la maille correspond à celle d'un substrat monocristallin en GaSb ou AlSb sur lequel ce composé peut être produit par des procédés maintenant bien maîtrisés.

Dans ce but l'invention propose un composé pour transducteur infrarouge constitué par l'alliage quaternaire (In₁₋ₓTlₓ)(As_{1-y}Sb_{y})
où 0<x<1 et 0<y<1

Un transducteur est alors constitué par une couche d'un tel matériau épitaxié sur un substrat qui sera généralement GaSb ou AlSb.

Il suffit de faibles teneurs en Sb et T1 pour obtenir des bandes interdites E₀ correspondant aux bandes 3 à 5 µm et 8 à 12 µm. Du fait de ces faibles teneurs, on conserve la structure cristalline blende de zinc de In (As, Sb), de sorte qu'on ne rencontre pas de difficulté de croissance épitaxiale, en mettant en oeuvre des procédés se rapprochant de ceux, bien connus, qui sont utilisés pour la constitution de couches épitaxiées de InAs, InSb et d'alliages ternaires InAs_{1-y} Sb_{y}. Ces faibles teneurs en Tl et Sb amènent la maille du réseau cristallin à une valeur correspondant à celle des monocristaux de GaSb ou AlSb, utilisés pour constituer le substrat d'épitaxie.

Les détecteurs destinés à la bande 8-12 µm doivent fonctionner à une température basse, généralement de l'ordre de 80 K. A cette température la longueur d'onde de coupure pour la bande 8-12 µm correspond sensiblement à E₀= 0,1 eV; la coupure pour la bande 3-5 µm correspond sensiblement à 0,25 eV. L'alliage quaternaire défini plus haut, permet d'obtenir une maille correspondant à celle d'un tel substrat monocristallin en GaSb ou AlSb.

Etant donné qu'on ne sait pas à l'heure actuelle réaliser des monocristaux de TlAs, la dimension de maille de ce composé ne peut qu'être calculée approximativement par diverses approches. Toutes permettent de déterminer avec un degré suffisant de précision les compositions précises à adopter pour le composant quaternaire. Dans la pratique, pour un détecteur destiné à fonctionner à 80K, les résultats satisfaisants sont obtenus avec des composants à teneur très majoritaire en InAs. Pour obtenir un accord de maille avec le substrat GaSb ou AlSb dans les bandes 3 à 5 µm (E₀=0,25 eV) et 8-12 µm (E₀=0,10 eV) on a obtenu :
substrat GaSb
   - bande 3-5 µm :: y = 7 à 8% x = 4 à 5%
   - 8-12 µm :: y = 3 à 6% x = 12 à 15%
substrat AlSb (1)
   - 8-12 µm :: y = 14 à 16% x = 8 à 10%

Dans la pratique on constitue des transducteurs à infra-rouge comprenant un substrat binaire supportant une couche epitaxiée (In₁₋ₓTlₓ) (As_{1-y}Sb_{y}), avec des valeurs de x et y très inférieures à 1, généralement inférieures à 0,2.

Le transducteur peut comporter, à sa partie supérieure, une couche d'accumulation dopée n+, la couche principale étant de type p ; la disposition peut être inversée.

Les caractéristiques ci-dessus ainsi que d'autres apparaîtront mieux à la lecture de la description qui suit de modes particuliers de réalisation, donnés à titre d'exemples non limitatifs. La description se réfère aux dessins qui l'accompagnent, dans lesquels :
la figure 1 est un diagramme montrant la variation de la bande interdite E₀ en fonction de la maille cristalline, dans le domaine de composition des alliages quaternaires (InTl)(AsSb)
les figures 2, 3 et 4 montrent trois structures de transducteurs infrarouges conformes à l'invention.

Le composé ayant pour composants majeurs de l'indium et de l'arsenic, utilisable dans un transducteur infrarouge récepteur ou émetteur, est sélectionnée en fonction de la plage de longueur d'onde dans laquelle le transducteur doit opérer et du substrat choisi, qui sera en général GaSb ou AlSb.

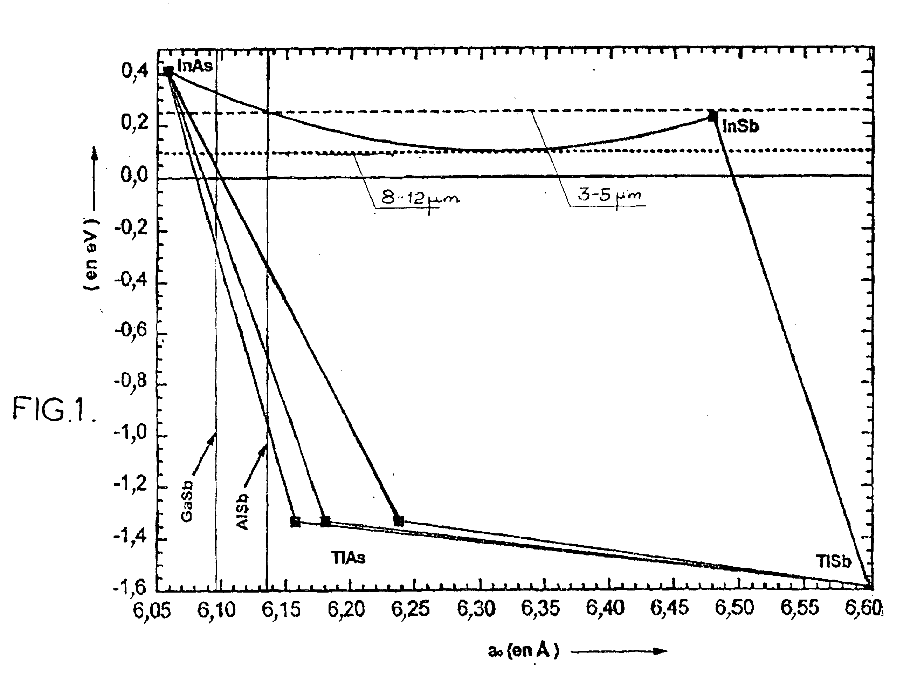

Le diagramme de la figure 1 montre la bande interdite et la dimension de maille cristalline a₀ pour InAs, InSb,TlSb et TlAs. Les paramètres de maille cristalline des composés InAs et InSb sont connus avec une grande précision. Les paramètres de TlSb, qui n'a pas été synthétisé dans la structure blende de zinc, ont été calculées par diverses approches qui ont toutes donné une valeur très proche de 6,6Å (1 Å = 0,1 nm). La figure 1 donne une plage de valeur possible pour la maille de TlAs qui n'a jamais non plus été synthétisée dans la structure blende de zinc et pour laquelle le calcul donne des valeurs qui évoluent entre 6,15 Å et 6,24 Å. A titre illustratif la fig. 1 donne trois exemples de résultats de tels calculs conduits dans ces intervalles, à savoir 6,15%Å ; 6,18Å et 6,238Å. Pour les ternaires In(As,Sb) la variation de la bande interdite et de la maille cristalline en fonction de la composition est bien connue. Les limites du domaine de l'alliage quaternaire issu de Tl As et Tl Sb ont été assimilées à des droites reliant les points représentatifs des autres composés binaires, ce qui donne une précision suffisante étant donné que les teneurs en Tl et Sb sont faibles.

La figure 1 montre également les dimensions de maille pour GaSb et AlSb, qui sont respectivement de 6,096 Å et 6,136 Å. Pour réduire la densité de défauts, notamment les dislocations provoquées par des désadaptations réticulaires entre couche épitaxiée et substrat, le composé à utiliser doit avoir une maille qui correspond à celle du substrat, c'est à dire se trouver sur une des lignes verticales de la figure 1, correspondant à GaSb et AlSb.

De plus, la bande interdite doit correspondre au domaine de longueur d'onde prévu pour le transducteur, à la température de fonctionnement de ce dernier. La figure 1 montre, pour une température de 80K, les valeurs de la bande interdite E = 0,25 eV pour la bande 3-5 µm et E = 0,1 eV pour 8-12 µm.

Sur le diagramme, on voit qu'il est toujours possible de réaliser à la fois un accord de maille avec le substrat et une bande interdite appropriée aux bandes 3-5 µm et 8-12 µm, et cela pour des compositions très proches de InAs.

Un transducteur fonctionnant uniquement dans la bande 3-5 µm peut être maintenu à une température plus élevée que 80 K et dans ce cas la bande interdite se déplace, mais il reste possible de trouver une composition quaternaire respectant les deux critères à la fois, et en particulier la valeur de la bande interdite (qui fixe la longueur d'onde de coupure dans le cas d'un détecteur, le maximum d'émission dans le cas d'un émetteur).

A titre d'exemple, si on admet que la dimension de maille pour TlAs est de 6,157 À, ce qui semble le cas le plus probable, on obtient les valeurs ci-après, qui sont bien comprises dans les intervalles donnés en (1).
substrat GaSb :
   - bande 3-5 µm :: y = 7,7% x = 5%
   - 8-12 µm :: y = 5,4% x = 14,7%
substrat AlSb :
   (1)
   - 8-12 µm :: y = 16% x = 8,3%

Il faut remarquer que l'adoption d'une dimension de maille a₀ pour TlAs de 6,238 Å au lieu de 6,157 Å change très peu la composition optimale. Cette composition serait :
substrat GaSb :
   - bande 3-5 µm :: y = 7,0% x = 4,6%
   - 8-12 µm :: y = 3,5% x = 12,9%
substrat AlSb :
   - 8-12 µm :: y = 14,3% x = 9,5%

On donnera maintenant, à titre d'exemples, plusieurs structures possibles de transducteurs conformes à l'invention. Dans tous les cas, la couche de composé quaternaire peut être réalisée par croissance épitaxiale, par exemple en phase vapeur par pyrolyse de composés organo-métalliques ou sous ultra-vide par jets moléculaires atomiques ou chimiques. Il s'agit là de techniques maintenant bien maîtrisées. Comme on le verra, on peut réaliser aussi bien des structures de détecteur permettant l'éclairement par la face arrière et l'hybridation par raccordement avec des billes d'indium, que des structures à éclairement par la face avant.

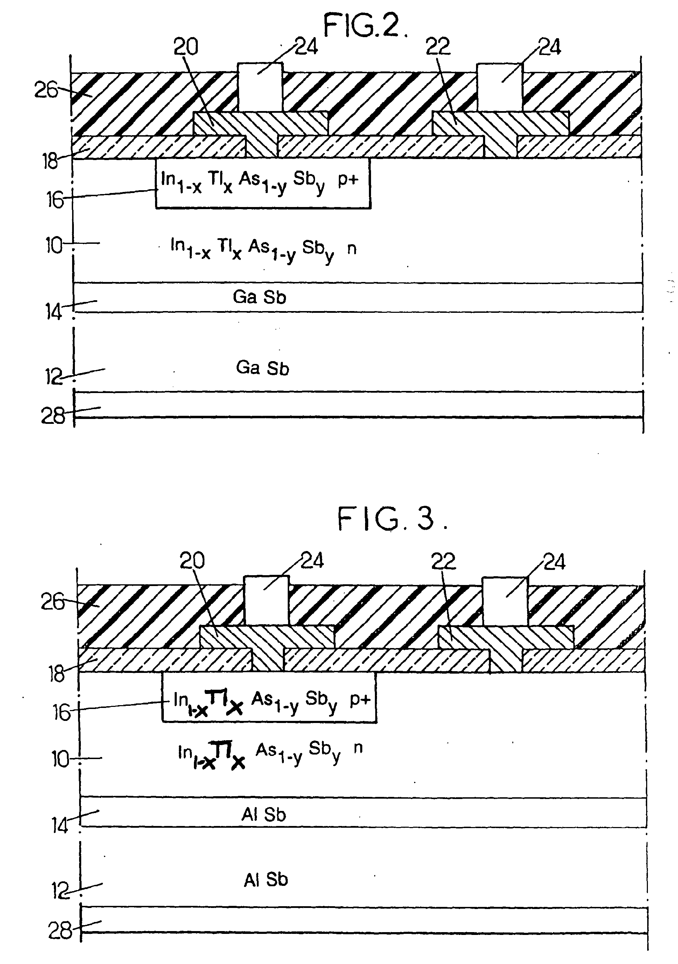

La structure montrée en figure 2 comporte une couche 10 d'alliage quaternaire (In₁₋ₓTlₓ)(As_{1-y}Sb_{y}) dopé n sur un substrat 12 de GaSb monocristallin non dopé.

Au cours d'une première étape, on dépose, sur le substrat 12 dont l'épaisseur sera généralement de l'ordre de 500 µm lorsqu'on souhaite réaliser une matrice de 256 x 256 sites photosensibles, une couche mince 14 de GaSb. Cette couche, dont l'épaisseur sera généralement de 10 à 100 nm, est destinée à constituer un tampon qui efface les défauts de surface du substrat. Elle peut être constituée par homo-épitaxie.

La couche active (In₁ₓTlₓ)(As_{1-y}Sb_{y}) dopée n est ensuite constituée, par exemple par croissance épitaxiale. On peut utiliser l'épitaxie par jet moléculaire ou en phase vapeur à partir de composés organo-métalliques. La composition de la couche est ajustable par des moyens connus, par exemple en agissant sur les vitesses d'évaporation des composants de départ utilisés. En général, on adoptera une couche 10 d'environ 10 µm d'épaisseur.

De façon à constituer un réseau de détecteurs semiconducteurs à jonction, on constitue des îlots à dopage p+ pour chaque site photo-sensible à réaliser. Ces îlots 16 sont par exemple constitués soit par implantation d'ions Be ou Mg par exemple, soit par diffusion d'impuretés, soit par épitaxies localisées.L'implantation de Be ou Mg dégrade peu la maille cristalline.

Une couche de passivation 18 est ensuite déposée sur la surface. Cette couche peut être constituée d'oxyde natif ou d'un dépôt mince de sulfure de zinc, dont la structure de blende lui permet de bien s'accrocher sur la couche active 10. Pour des raisons de transparence on pourra notamment utiliser ZnS pour des détecteurs travaillant en bande 8-12 µ et l'oxyde de silicium SiO₂ pour des détecteurs travaillant en bande 3-5 µm,

Les contacts ohmiques nécessaires peuvent ensuite être réalisés par des processus classiques de photo-lithographie et de dépôt de métal. Pour chaque site photosensible, on constitue un contact p 20 relié à un îlot 16 et un contact n 22 relié à la couche active de type n.

On peut notamment utiliser, comme métal constitutif des contacts, Al, Au, Ni, Pt, Ti-W.

Il est également possible de constituer les îlots 16 dopés p+ après dépôt d'une couche de passivation et photo-lithographie, avant mise en place des contacts 20 et 22.

Lorsque le détecteur est destiné à être fixé sur un substrat et éclairé par sa face arrière, il est muni de billes d'indium 24 permettant de le fixer sur un circuit intégré de lecture sur substrat silicium. Pour cela on constitue une couche 26 d'isolant, pouvant notamment être constituée de ZnS ou SIO₂. Des passages sont ménagés dans cette couche par photo-lithographie et reçoivent des microbilles d'indium.

Après hybridation de la structure par fixation des billes d'indium sur le circuit de lecture, le substrat 12 peut être aminci pour augmenter sa transparence et la face arrière est en général recouverte d'une couche de passivation et d'une couche anti-reflet.

La figure 3 montre une variante de réalisation comportant la même structure, mais avec une couche active de composé (In₁₋ₓ Tlₓ)(As_{1-y}Sb_{y}) sur substrat AlSb, pour constituer un détecteur travaillant dans la bande 8 - 12 µm. Avec un alliage connu, par exemple du brevet US-A-4 184 171, de In(As_{1-y}Sb_{y}) (y = 0,18 - 0,19) un détecteur travaillant en bande 3 - 5 µm peut être réalisé.

Le mode de réalisation est le même que dans le cas précédent et les mêmes numéros de référence désignent les éléments correspondants des figures 2 et 3.

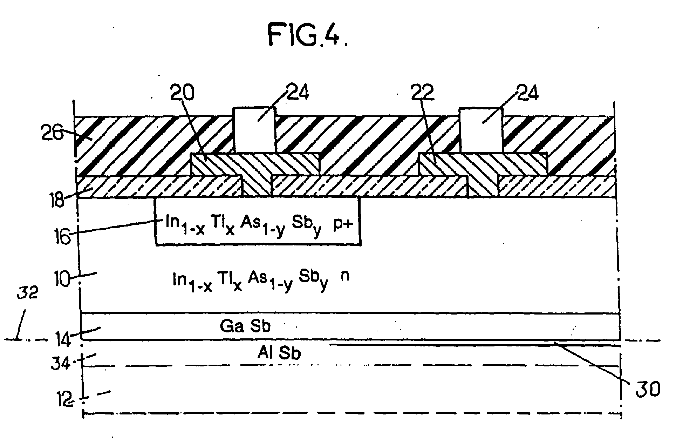

La figure 4, où les éléments correspondant à ceux de la figure 2 sont encore désignés par les mêmes numéros de référence, diffère notamment de la précédente en ce qu'au cours de la fabrication on dépose une couche intermédiaire 34 en AlSb, ayant une maille très proche de celle du substrat de GaSb. Cette couche 34 peut être dissoute de manière sélective après hybridation de la structure, ce qui permet de décoller le détecteur du substrat non dopé 12. Après décollement au niveau de la ligne 32, on dépose une couche très mince 30 de GaSb dopé n+ afin d'assurer un bon état de surface et on ajoute une couche finale de passivation anti-reflet, similaire à la couche 28. Une telle constitution permet d'éviter l'étape d'amincissement du substrat par voie mécano-chimique, nécessaire dans le cas de la fig. 2.

Il est également possible de constituer des détecteurs à éclairement par la face avant et des photoémetteurs à émission par la face avant en utilisant des couches de matériau isolant et de passivation transparentes à la longueur d'onde choisie, par exemple ZnS en bande 8-12 µm et SIO2 en bande 3-5 µm.

De nombreuses variantes de réalisation sont encore possibles.

Lorsque le transducteur est destiné à fonctionner avec éclairement ou émission en face avant, sans hybridation, une fenêtre à matériau approprié peut être ajoutée sur la face avant. Cette fenêtre sera généralement en GaSb dopé n+.

Les dopages indiqués sur les figures 2 à 4 peuvent être inversés et on peut utiliser Cd et Zn comme impureté de dopage.

Par ailleurs, il est possible de réaliser une matrice de détection fonctionnant à la fois en bande 3-5 µm et en bande 8-12 µm en constituant, sur un même substrat GaSb ou AlSb, des sites imbriqués en damier et correspondant à des plages de fonctionnement différentes. Il est également possible de constituer des transducteurs du genre montré en figure 2, 4 prévus pour la bande 8-12 µm et d'y superposer des sites photosensibles prévus pour 3-5 µm, placés en face avant. Dans ce cas, la température de fonctionnement choisie doit être suffisamment basse pour un fonctionnement satisfaisant dans la bande 8-12 µm.

## Revendications

1. Alliage pour transducteur infra-rouge, constitué par (In₁₋ₓTlₓ) (As_{1-y}Sb_{y}) où 0<x<1 et 0<y<1, de composition telle que sa dimension de maille soit égale à celle de GaSb ou AlSb.

2. Transducteur infra-rouge comprenant, sur un substrat GaSb ou AlSb, une couche active de composé (In₁₋ₓTlₓ) (As_{1-y}Sb_{y}) où 0<x<1 et 0<y<1 de composition telle que sa dimension de maille soit égale à celle du matériau de substrat.

3. Transducteur pour la bande 3-5 µm selon la revendication 2, **caractérisé en ce que** les valeurs de x et y sont : sur substrat GaSb : y = 7 à 8% x = 4 à 5%

4. Transducteur pour la bande 8-12 µm selon la revendication 2, **caractérisé en ce que** les valeurs de x et y sont : sur substrat GaSb : 8-12 µm : y = 3 à 6% x = 12 à 15% sur substrat AlSb : y = 14 à 16% x = 8 à 10%

5. Transducteur selon la revendication 3 ou 4, **caractérisé en ce que** la couche active étant dopée n, le transducteur comporte à sa partie avant des îlots à dopage p+ pour chaque site à réaliser.

6. Transducteur selon la revendication 5, **caractérisé en ce qu'**il comprend au moins un site pour la bande 3-5 µm et au moins un site pour la bande 8-12 µm, lesdits sites étant imbriqués en damier.

7. Transducteur selon la revendication 5, **caractérisé en ce qu'**il est adapté pour la bande 8-12 µm et **en ce que** des sites photosensibles adaptés pour la bande 3-5 µm sont superposés sur ledit transducteur, en face avant.

8. Procédé de fabrication d'un transducteur selon la revendication 2, suivant lequel :
on dépose la couche active dopée n ou p par épitaxie,
on constitue des îlots (16) à dopage p+ ou n+ pour chaque site à réaliser, par implantation d'ions ou diffusion d'impuretés,
on dépose une couche de passivation (12),
on constitue des contacts ohmiques (20, 22) sur lesquels on dépose des microbilles d'indium, on hybride la structure ainsi réalisée par fixation des billes d'indium sur un circuit de lecture, et
on amincit le substrat pour augmenter sa transparence.

9. Procédé de fabrication d'un transducteur selon la revendication 2, suivant lequel :
on dépose sur un substrat en GaSb une couche intermédiaire (34) en AlSb ;
on dépose la couche active dopée n ou p par épitaxie ;
on constitue des îlots (16) à dopage p+ ou n+ pour chaque site à réaliser, par implantation d'ions ou diffusion d'impuretés ;
on dépose une couche de passivation (12) ;
on constitue des contacts ohmiques (20, 22) sur lesquels on dépose des microbilles d'indium, on hybride la structure ainsi réalisée par fixation des billes d'indium sur un circuit de lecture ;
on dissout sélectivement la couche intermédiaire (34) pour décoller le substrat ;
on dépose une couche mince (30) de GaSb dopée n+ ; et
on ajoute une couche de passivation.

## Claims

1. An alloy for an infrared transducer, the alloy being constituted by (In₁₋ₓTlₓ) (As_{1-y}Sb_{y}) where 0 < x < 1 and 0 < y < 1, the alloy being of the composite such that its lattice constant is of a size equal to that of GaSb or AlSb.

2. An infrared transducer comprising, on a GaSb or an AlSb substrate, an active layer of the (In₁₋ₓTlₓ) (AS_{1-y}Sb_{y}) compound where 0 < x < 1 and 0 < y < 1 of a composition such that its lattice constant is of a size that is equal to that of the substrate material.

3. A transducer for the 3 µm - 5 µm band according to claim 2, **characterized in that** the values of x and y are as follows:
for a GaSb substrate: y = 7% to 8% x = 4% to 5%

4. A transducer for the 8 µm - 12 µm band according to claim 2, **characterized in that** the values of x and y are as follows:
for a GaSb substrate: 8-12 µm: y = 3% to 6% x = 12% to 15%
for a AlSb substrate: y = 14 to 16% x = 8% to 10%.

5. A transducer according to claim 3, or 4 **characterized in that** for an n-doped active layer, the transducer includes on its front portion, p+ doped islands for each site to be made.

6. A transducer according to claim 5, **characterized in that** it comprises at least one site for the 3-5 µm range and at least one site for the 8-12 µm range, said sites being interleaved in a checkerboard.

7. A transducer according to claim 5, **characterized in that** it is adapted for the 8-12 µm range and **in that** photosensitive sites adapted for the 3-5 µm range are overlaid on said transducer, front face.

8. A method of manufacturing a transducer according to claim 2, wherein:
the n- or p- doped active layer is deposited by epitaxy;
p+ or n+ doped islands (16) are formed for each site to be made, by implanting ions or by diffusing impurities;
a passivation layer (12) is deposited;
ohmic contacts (20, 22) are formed on which indium microbeads are deposited;
the resulting structure is hybridized by fixing the indium microbeads on a read circuit; and
the substrate is thinned to increase its transparency.

9. A method of manufacturing a transducer according to claim 2, wherein:
an intermediate layer (34) of AlSb is deposited on a GaSb substrate;
the n or p doped active layer is deposited by epitaxy;
p+ or n+ doped islands (16) are formed for each site to be made, by implanting ions or by diffusing impurities;
a passivation layer (12) is deposited;
ohmic contacts (20, 22) are formed on which indium microbeads are deposited;
the resulting structure is hybridized by fixing indium beads on the read circuit;
the intermediate layer is selectively dissolved to remove the substrate;
a thin layer (30) of n⁺ doped GaSb is deposited; and
a passivation layer is added.

## Patentansprüche

1. Legierung für einen IR-Wandler, dargestellt durch (In₁₋ₓTlₓ)(As_{1-y}Sb_{y}), worin gilt: 0 < x < 1 und 0 < y < 1, mit einer solchen Zusammensetzung, dass ihre Gitterabmessung derjenigen von GaSb oder von AlSb gleicht.

2. IR-Wandler, umfassend, auf einem GaSb- oder AlSb-Substrat, eine Aktivschicht der Verbindung (In₁₋ₓTlₓ)(As_{1-y}Sb_{y}), worin gilt: 0 < x < 1 und 0 < y < 1, mit einer solchen Zusammensetzung, dass ihre Gitterabmessung derjenigen des Substratmaterials gleicht.

3. Wandler gemäß Anspruch 2 für die Bande von 3 bis 5 µm, **dadurch gekennzeichnet, dass** die Werte von x und y sind: auf dem GaSb-Substrat: y = 7 bis 8 % und x = 4 bis 5 %.

4. Wandler gemäß Anspruch 2 für die Bande von 8 bis 12 µm, **dadurch gekennzeichnet, dass** die Werte von x und y sind:
auf dem GaSb-Substrat: 8 bis 12 µm: y = 3 bis 6 % und x = 12 bis 15 %,
auf dem AlSb-Substrat: y = 14 bis 16 % und x = 8 bis 10 %.

5. Wandler gemäß Anspruch 3 oder 4, **dadurch gekennzeichnet, dass** bei n-dotierter Aktivschicht der Wandler auf seinem Vorderteil kleine Inseln mit einer p⁺-Dotierung für jede herzustellende Stelle aufweist.

6. Wandler gemäß Anspruch 5, **dadurch gekennzeichnet, dass** er mindestens eine Stelle für die Bande von 3 bis 5 µm und mindestens eine Stelle für die Bande von 8 bis 12 µm umfasst, wobei die genannten Stellen schachbrettartig verschachtelt sind.

7. Wandler gemäß Anspruch 5, **dadurch gekennzeichnet, dass** er für die Bande von 8 bis 12 µm ausgestaltet ist, und dass Stellen, die für die Bande von 3 bis 5 µm lichtempfindlich ausgestaltet sind, auf dem genannten Wandler auf der Vorderseite angeordnet werden.

8. Verfahren zur Herstellung eines Wandlers gemäß Anspruch 2, wobei man:
die n- oder p-dotierte Aktivschicht durch Epitaxie abscheidet,
kleine Inseln (16) mit p⁺- oder n⁺-Dotierung für jede herzustellende Stelle durch Implantation von Ionen oder durch Diffusion von Verunreinigungen erzeugt,
eine Passivierungsschicht (12) abscheidet,
Ohm'sche Kontakte (20, 22), auf denen man Mikrokugeln aus Indium abscheidet, und die so erhaltene Struktur durch Fixierung der Kugeln aus Indium auf einem Mess-Schaltkreis als Hybrid erzeugt und man
das Substrat zur Erhöhung seiner Durchsichtigkeit dünner macht.

9. Verfahren zur Herstellung eines Wandlers gemäß Anspruch 2, wobei man:
auf einem Substrat aus GaSb eine Zwischenschicht (34) aus AlSb abscheidet,
die n- oder p-dotierte Aktivschicht durch Epitaxie abscheidet,
kleine Inseln (16) mit p⁺- oder n⁺-Dotierung für jede herzustellende Stelle durch Implantation von Ionen oder durch Diffusion von Verunreinigungen erzeugt,
eine Passivierungsschicht (12) abscheidet,
Ohm'sche Kontakte (20, 22), auf denen man Mikrokugeln aus Indium abscheidet, und die so hergestellte Struktur durch Fixierung der Kugeln aus Indium auf einem Mess-Schaltkreis als Hybrid erzeugt,
selektiv die Zwischenschicht (34) auflöst, um das Substrat abzulösen,
eine dünne Schicht (30) aus n⁺-dotiertem GaSb abscheidet und man
eine Passivierungsschicht zufügt.
